Europäisches Patentamt

European Patent Office

Office européen des brevets

(11) Publication number : **0 471 502 A1**

# EUROPEAN PATENT APPLICATION

(21) Application number : **91307248.4**

(22) Date of filing : **07.08.91**

(51) Int. Cl.⁵ : **H03L 7/189**

(30) Priority : **13.08.90 JP 214102/90**

(43) Date of publication of application :
**19.02.92 Bulletin 92/08**

(84) Designated Contracting States :
**DE FR GB**

(71) Applicant : **FUJITSU LIMITED**
**1015, Kamikodanaka Nakahara-ku**
**Kawasaki-shi Kanagawa 211 (JP)**

(72) Inventor : **Asami, Fumitaka**
**1-27, 1-23-202, Fujimidai**
**Kunitachi-shi, Tokyo 186 (JP)**

(74) Representative : **Billington, Lawrence Emlyn et**
**al**
**HASELTINE LAKE & CO Hazlitt House 28**
**Southampton Buildings Chancery Lane**
**London WC2A 1AT (GB)**

(54) **Phase locked loop circuit and semiconductor integrated circuit using the phase locked loop circuit.**

(57)   A PLL circuit is operatively coupled to a power source and comprises a phase comparator (2, 3) for comparing phases of an input signal and a feedback signal, a memory (7, 8) for storing information related to the input signal, a control voltage output circuit (15) for outputting a control voltage based on the information read out from the memory, and a feedback loop circuit (4, 5, 10) including a voltage controlled oscillator (5) whose oscillation frequency is controlled by the control voltage received from the control voltage output circuit. The feedback loop circuit supplies a signal which is derived from an output signal of the voltage controlled oscillator to the phase comparator as the feedback signal. The use of the memory means (7, 8) allows the PLL circuit to lock to a target frequency within a short time regardless of the time constant of the feedback loop.

EP 0 471 502 A1

## FIG.5

## BACKGROUND OF THE INVENTION

The present invention generally relates to phase locked loop (PLL) circuits and semiconductor integrated circuits using PLL circuits, and more particularly to a PLL circuit which is used for demodulating period of analog and digital modulated waves, bit synchronization, frequency synthesis and the like, and a semiconductor integrated circuit which uses such a PLL circuit.

Recently, PLL circuits have been reduced in size accompanied by the high integration density and high performance of analog large scale integrated circuits (LSIs). The PLL circuit is used for demodulating period of analog and digital modulated waves, bit synchronization, frequency synthesis and the like.

In a mobile telephone, a pager terminal (pocket bell) and the like, circuits are operated only when required (intermittent operation) or, a frequency hopping is made in which the carrier frequency is successively hopped in synchronism with a change in the the state of the code depending on a sequence defined by a code sequence. In such applications, it is necessary to minimize the lock-up time of the PLL circuit which is required for the frequency of a target output signal to reach a target frequency.

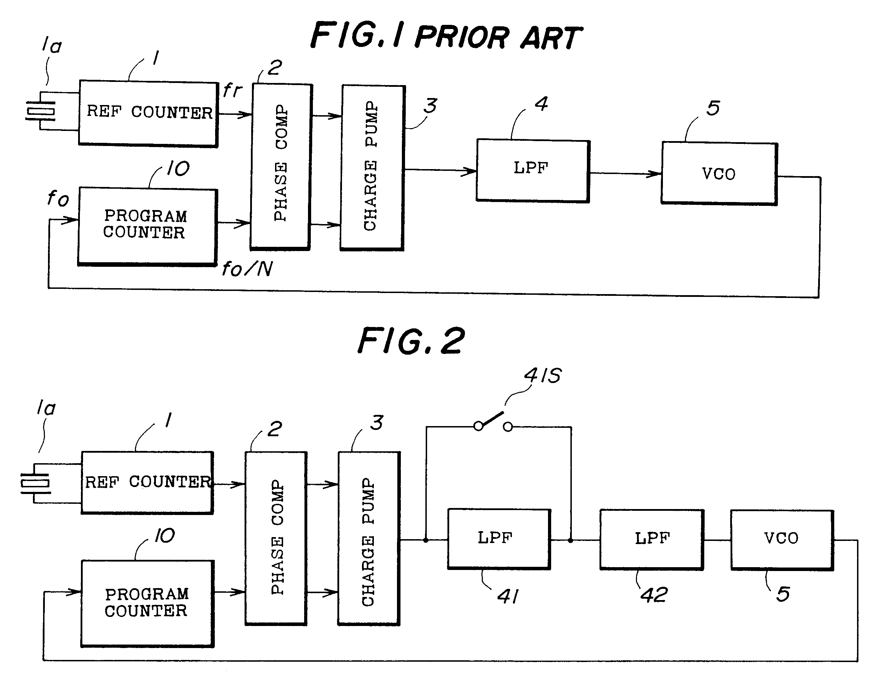

Conventionally, there is a PLL circuit of the type shown in FIG.1. In FIG.1, a reference counter 1 subjects an output oscillation frequency of a crystal oscillator 1a to a comparison and multiplication to output a reference frequency $f_r$. A phase comparator 2 compares the reference frequency $f_r$ with a divided frequency $f_0/N$ which is fed back, and outputs a control voltage dependent on a phase error between the two compared frequencies. A charge pump 3 boosts the output control voltage of the phase comparator 2 to a predetermined voltage and outputs a control voltage $V_C$. A lowpass filter 4 smoothens the output control voltage $V_C$ of the charge pump 3, and a voltage controlled oscillator (VCO) 5 outputs a signal having an oscillation frequency $f_0$ which is proportional to an analog value of the control voltage $V_C$. A programmable counter 10 divides the oscillation frequency $f_0$ by N and supplies the divided frequency $f_0/N$ to the phase comparator 2. The value of N may be set arbitrarily from outside the programmable counter 10.

Next, a description will be given of an operation of the PLL circuit shown in FIG.1. First, a power source switch (not shown) is turned ON, and a frequency dividing ratio 1/N of the programmable counter 10 is set. The crystal oscillator 1a starts to oscillate at a predetermined oscillation frequency when the power source switch turns ON, and this predetermined oscillation frequency is supplied to the phase comparator 2 via the reference counter 1. A closed loop circuit is formed by the phase comparator 2, the charge pump 3, the lowpass filter 4, the VCO 5 and the programmable counter 10. The control voltage $V_C$ is controlled by the feedback provided by the closed loop circuit so that the reference frequency $f_r$ matches the divided frequency $f_0/N$ at the phase comparator 2.

Therefore, the PLL circuit is locked to a predetermined target frequency by the feedback control of the closed loop circuit.

FIG.2 shows a conceivable PLL circuit of another type. In FIG.2, those parts which are the same as those corresponding parts in FIG.1 are designated by the same reference numerals, and a description thereof will be omitted. The PLL circuit shown in FIG.2 differs from that shown in FIG.1 in that two lowpass filters connected in series are selectively used by switching in FIG.2. In other words, first and second lowpass filters 41 and 42 are connected in series between the charge pump 3 and the VCO 5, and a switch 41S is provided in a bypass circuit which short-circuits the first lowpass filter 41.

By closing the open switch 41S to form the bypass circuit, it becomes possible to switch the time constant from a first value to a second value, where the first value is a sum of the time constants of the first and second lowpass filters 41 and 42 and the second value is the time constant of the second lowpass filter 42 alone. Hence, it is possible to reduce the lock-up time of the PLL circuit and cope with the frequency hopping. That is, the switch 41S is open so that the time constant has the first value when ensuring a satisfactory carrier-to-noise (C/N) ratio, and the switch 41S is closed so that the time constant has the second value when copying with the frequency hopping because the frequency changes at the instant when the frequency is switched and the C/N ratio does not have a significant meaning in this case.

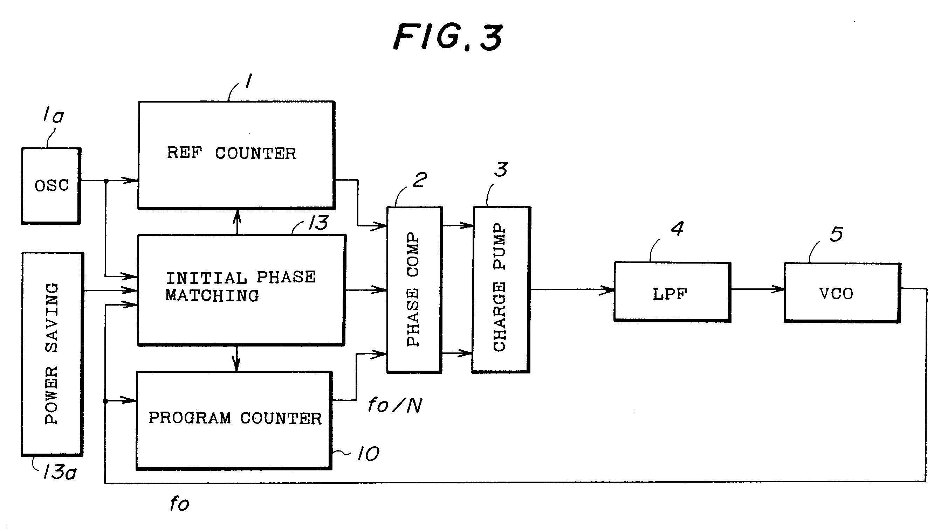

FIG.3 shows another conceivable PLL circuit of yet another type. In FIG.3, those parts which are the same as those corresponding parts in FIG.1 are designated by the same reference numerals, and a description thereof will be omitted. The PLL circuit shown in FIG.3 differs from that shown in FIG.1 in that an initial phase matching circuit and a power saving circuit are additionally provided in FIG.3. In other words, based on the oscillation frequency $f_0$ from the VCO 5, a power saving signal from a power saving circuit 13a and an oscillation frequency of the crystal oscillator 1a, an initial phase matching circuit 13 supplies to the reference counter 1, the phase comparator 2 and the programmable counter 10 initial phase signals which have identical frequencies and are used for matching initial phases. Hence, the initial phases of the signals from the reference counter 1 and the program counter 10 are matched at the phase comparator 2 by this initial phase matching.

When the power source switch is turned ON for the second time, the initial phase signals from the initial phase matching circuit 13 match the initial phases at the reference counter 1, the phase comparator 2 and the programmable counter 10 so as to reduce the time which is required to match the initial phases. As a result, the lock-up time during the intermitting operation can be reduced and it is possible to reduce the power consumption of the PLL circuit.

As described above, the lock-up time of the conventional PLL circuit shown in FIG.1 is determined by the time constant of the lowpass filter 4 because the output control voltage $V_C$ of the phase comparator 2 is supplied to the VCO 5 via the lowpass filter 4. For this reason, there are problems in that the time constant of the lowpass filter 4 cannot be made small when the C/N ratio is taken into consideration, and it is impossible to reduce the lock-up time.

In the case of the conceivable PLL circuit shown in FIG.2, the time constant of the lowpass filter 42 still exists even when the switch 41S is closed to switch the time constant to cope with the frequency hopping. In addition, there is a limit to reducing the lock-up time due to the resistance of the analog switch 41S which is used for the switching. Therefore, it is impossible to reduce the lock-up time to less than 10 msec, and there is a problem in that a dropout of data will occur when the frequency is changed during a digital data transmission.

On the other hand, the conceivable PLL circuit shown in FIG.3 is capable of reducing the lock-up time by the provision of the initial phase matching circuit 13 with respect to the intermittent operation in which the frequencies are quickly increased to a single frequency when the power source switch is turned ON for the second time. However, there is a problem in that the lock-up time cannot be reduced for the intermitting operation in which the frequency is changed.

## SUMMARY OF THE INVENTION

Accordingly, it is a general object of the present invention to provide a novel and useful PLL circuit and a semiconductor integrated circuit using the PLL circuit, in which the problems described above are eliminated.

Another and more specific object of the present invention is to provide a PLL circuit which is operatively coupled to a power source, comprising phase comparator means for comparing phases of an input signal and a feedback signal, memory means, coupled to the phase comparator means, for storing information related to the input signal, control voltage output means, coupled to the memory means, for outputting a control voltage based on the information read out from the memory means, and a feedback loop circuit, coupled to the control voltage output means, including a voltage controlled oscillator whose oscillation frequency is controlled by the control voltage received from the control voltage output means, where the feedback loop circuit supplies to the phase comparator means as the feedback signal a signal which is derived from an output signal of the voltage controlled oscillator. According to the PLL circuit of the present invention, it is possible to lock the PLL circuit to a target frequency within a short time regardless of the time constant of the feedback loop. Because the lock-up time is reduced, it is possible to reduce the power consumption of the PLL circuit. In addition, the lock-up time can be reduced even when the circuit characteristic of the voltage controlled oscillator and the like changes with time.

Still another object of the present invention is to provide a PLL circuit comprising phase comparator means for comparing phases of an input signal and a feedback signal and for outputting an output signal dependent on a phase error between the two compared signals, lowpass filter means, coupled to the phase comparator means, for filtering the output signal of the phase comparator means into a control signal, a feedback loop circuit including a voltage controlled oscillator which is coupled to the lowpass filter means, where the voltage controlled oscillator oscillates at an oscillation frequency controlled by the control signal received from the lowpass filter means and the feedback loop circuit supplies a signal which is derived from an output signal of the voltage controlled oscillator to the phase comparator means as the feedback signal, switching means, coupled to the lowpass filter means, having first and second states, an analog-to-digital converter, coupled to the switching means, for converting the control signal which is received from the lowpass filter means via the switching means in the first state into a digital signal, memory means, coupled to the analog-to-digital converter, for storing the digital signal output from the analog-to-digital converter, and a digital-to-analog converter, coupled to the memory means and the switching means, for converting the digital signal read out from the memory means into an analog signal and for supplying the analog signal to the switching means, where the switching means in the second state supplies the analog signal from the digital-to-analog converter to one of the lowpass filter means and the voltage controlled oscillator. According to the PLL circuit of the present invention, it is possible to lock the PLL circuit to a target frequency within a short time regardless of the time constant of the feedback loop. Because the lock-up time is reduced, it is possible to reduce the power consumption of the PLL circuit. In addition, the lock-up time can be reduced even when the circuit characteristic of the voltage controlled oscillator and the like changes with time.

A further object of the present invention is to provide the PLL circuit of the immediately preceding type wherein at least the phase comparator means, the switching means, the analog-to-digital converter, the memory means and the digital-to-analog converter are formed on a single semiconductor integrated circuit chip.

Other objects and further features of the present invention will be apparent from the following detailed description when read in conjunction with the accompanying drawings.

## BRIEF DESCRIPTION OF THE DRAWINGS

FIG.1 is a system block diagram showing a conventional PLL circuit;
FIG.2 is a system block diagram showing a conceivable PLL circuit;
FIG.3 is a system block diagram showing another conceivable PLL circuit;
FIG.4 is a system block diagram for explaining an operating principle of a first embodiment of a PLL circuit according to the present invention;
FIG.5 is a system block diagram showing the first embodiment;
FIG.6 is a system block diagram for explaining an operating principle of a second embodiment of the PLL circuit according to the present invention;
FIG.7 is a system block diagram showing the second embodiment;
FIG.8 is a system block diagram showing a first modification of the second embodiment; and
FIG.9 is a system block diagram showing a second modification of the second embodiment.

## DESCRIPTION OF THE PREFERRED EMBODIMENTS

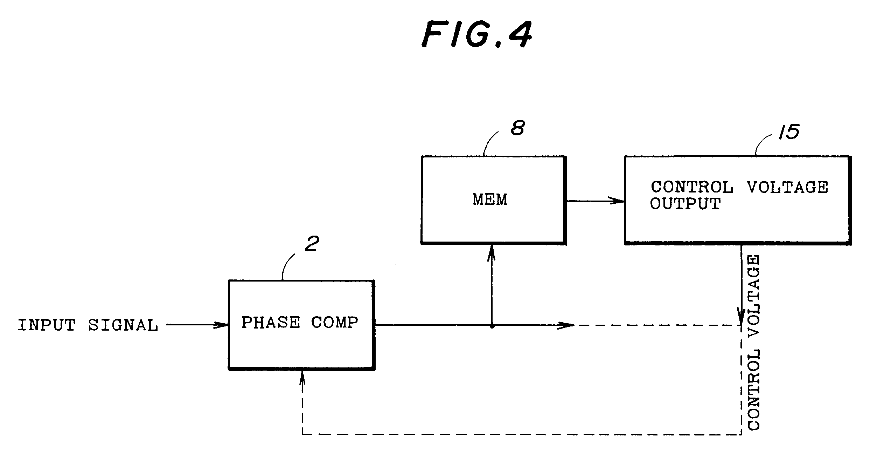

A description will be given of an operating principle of a first embodiment of a PLL circuit according to the present invention, by referring to FIG.4.

The PLL circuit shown in FIG.4 includes a phase comparator 2, a memory 8 and a control voltage output circuit 15. The phase comparator 2 compares the phases of an input signal and a control voltage which is fed back, and generates a comparison voltage dependent on the error between the two compared phases. The memory 8 stores information related to the input signal which is supplied to the phase comparator 2 at the time when the power source switch is turned ON, that is, at the time of a cold start. After the power source switch is turned ON, the control voltage output circuit 15 outputs a control voltage based on the information which is stored in the memory 8.

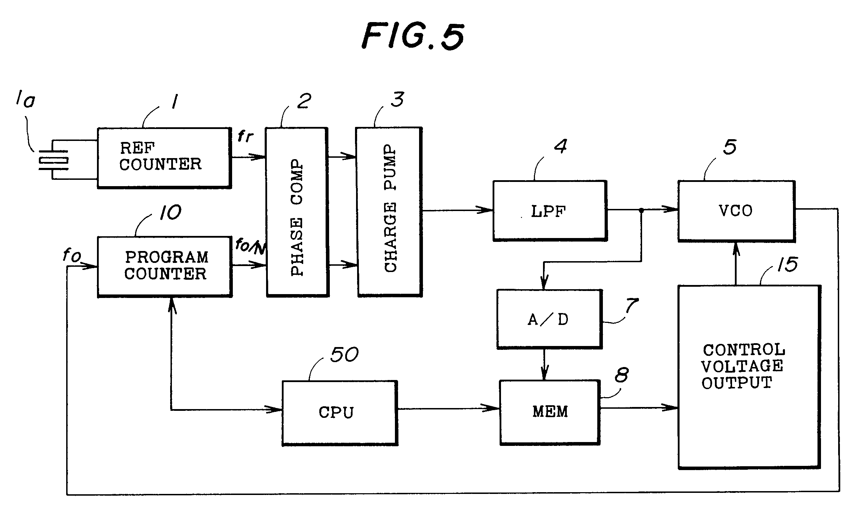

Next, a description will be given of the first embodiment of the PLL circuit according to the present invention, by referring to FIG.5. In FIG.5, those parts which are the same as those corresponding parts in FIGS.1 and 4 are designated by the same reference numerals, and a description thereof will be omitted. As shown in FIG.5, an analog-to-digital (A/D) converter 7 is coupled between the lowpass filter 4 and the memory 8, and the output control voltage of the control voltage output circuit 15 is supplied to the VCO 5. A central processing unit (CPU) 50 controls the operation of the program counter 10 including the frequency dividing ratio thereof, and the write and read operations of the memory 8 including storage locations within the memory 8.

When the power source switch is turned ON, a plurality of input signals which may be received are successively input to the phase comparator 2. Hence, a plurality of voltage data corresponding to the input signals are successively supplied from the A/D converter 7 to the memory 8 and stored under the control of the CPU 50 which controls the write operation of the memory 8. Of course, the memory 8 may store data other than the voltage data, such as frequency data corresponding to the input signals.

When receiving a specific input signal after the power source switch is turned ON, the CPU 50 controls the read operation of the memory 8 so as to read the voltage data corresponding to the specific input signal. Hence, the read voltage data is supplied to the control voltage output circuit 15 which includes a digital-to-analog (D/A) converter (not shown), and the control voltage output circuit 15 outputs a predetermined analog control voltage based on the voltage data. As a result, the oscillation of the VCO 5 is controlled by the predetermined analog control voltage from the control voltage output circuit 15, and the output of the VCO 5 is fed back to the phase comparator 2 via the program counter 10.

If the target input signal is to be switched from the specific input signal to another input signal, the voltage data corresponding to this other input signal is similarly read out from the memory 8 and supplied to the control voltage output circuit 15. The oscillation of the VCO 5 is controlled by an analog control voltage which is output from the control voltage output circuit 15 based on the read voltage data, and the output of the VCO 5 is fed back to the phase comparator 2 via the program counter 10.

According to this embodiment, the lock-up time can be reduced effectively because it is possible to eliminate the undesirable effects of the elements which exist in the closed loop circuit and have a time constant. In other words, the PLL circuit can lock to an arbitrary target frequency without being affected by the time constant of the lowpass filter 4, because the control voltage supplied to the VCO 5 is generated based on the voltage data which is read from the memory 8. The voltage data can be read out from the memory 8 within a short time and the lock-up time is virtually unaffected relative to the read out time. In addition, the power consumption of the PLL circuit can be reduced since the lock-up time can be reduced. Furthermore, even when the circuit characteristic of the VCO 5 and the like changes with time, the memory 8 always stores the voltage data for the present circuit characteristic. Therefore, the lock-up time can be reduced even when the circuit characteristic of the VCO 5 and the like changes with time.

FIG.5 shows the case where the first embodiment is applied to the type of PLL circuit shown in FIG.1. However, the first embodiment can similarly be applied to the types of PLL circuits shown in FIGS.2 and 3.

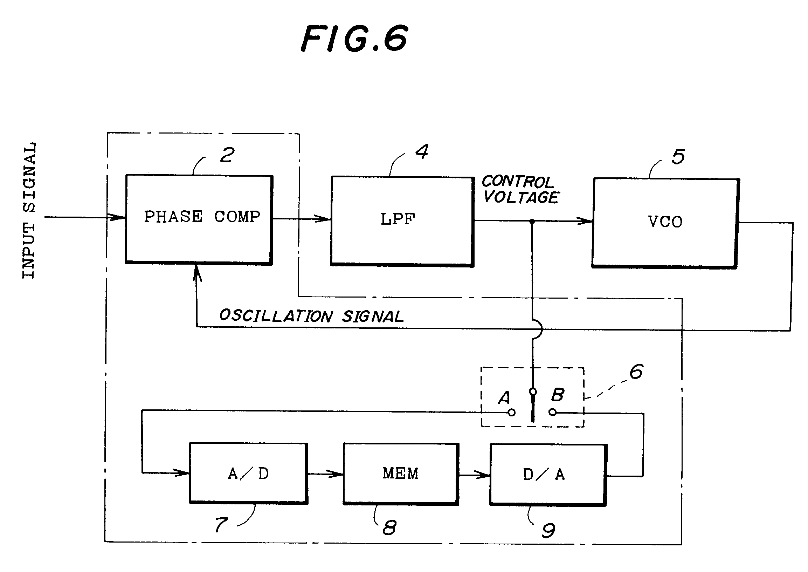

Next, a description will be given of an operating principle of a second embodiment of the PLL circuit according to the present invention, by referring to FIG.6. In FIG.6, those parts which are the same as those corresponding parts in FIGS.4 and 5 are designated by the same reference numerals, and a description thereof will be omitted.

As shown in FIG.6, the PLL circuit includes a phase comparator 2, a lowpass filter 4, a VCO 5, a switch 6, an A/D converter 7, a memory 8 and a D/A converter 9 which are coupled as shown. For example, a circuit part surrounded by a one-dot chain line is formed as a semiconductor integrated circuit (LSI chip). By using such an LSI chip, it is possible to reduce the size and increase the operation speed of the PLL circuit, and also improve the characteristic of the PLL circuit with respect to noise.

The switch 6 is connected to a position A when the power source switch is turned ON. For this reason, the output control voltage of the lowpass filter 4 is supplied to the A/D converter 7 via the switch 6, and an output digital control signal of the A/D converter 7 is stored in the memory 8. The digital control signal from the A/D converter 7 is stored for a plurality of channels of the input signal which is applied to the phase comparator 2 every time the power source switch is turned ON.

After the power source switch is turned ON and the output digital control signal of the A/D converter 7 is stored in the memory 8 for all of the desired channels, the switch 6 is switched to a position B. Hence, the digital control signal read out from the memory 8 is converted into the analog control voltage in the D/A converter 9 before being supplied to the VCO 5 via the switch 6. In other words, the VCO 5 is controlled by the control voltage which is derived from the digital control signal which is stored in the memory 8 at the time when the power source switch is turned ON.

According to this embodiment, the digital control signal is stored in the memory 8 for a plurality of channels at the time when the power source switch is turned ON, and the VCO 5 is controlled based on the digital control signal which is read out from the memory 8. Therefore, the PLL circuit can be locked to an arbitrary target frequency substantially by the time which is required to read the digital control signal from the memory 8, without being affected by the time constant of the lowpass filter 4 and the like. For this reason, the power consumption of the PLL circuit can be reduced since the lock-up time can be reduced. Furthermore, even when the circuit characteristic of the VCO 5 and the like changes with time, the memory 8 always stores the digital control signal for the present circuit characteristic. Accordingly, the lock-up time can be reduced even when the circuit characteristic of the VCO 5 and the like changes with time.

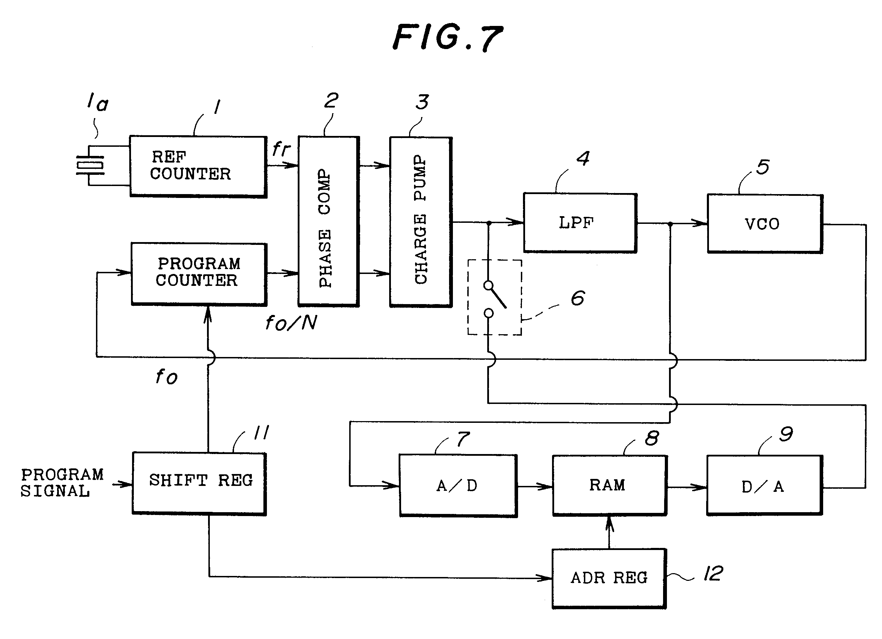

Next, a description will be given of the second embodiment of the PLL circuit according to the present invention, by referring to FIG.7. In FIG.7, those parts which are the same as those corresponding parts in FIGS.1 and 6 are designated by the same reference numerals, and a description thereof will be omitted.

As shown in FIG.7, the PLL circuit includes in addition to the elements shown in FIG.1, a switch 6, an A/D converter 7, a memory 8, a D/A converter 9, a shift register 11 and an address register 12 which are coupled as shown. In this embodiment, the memory 8 is a random access memory (RAM). In addition, the switch 6 is provided between an input end of the lowpass filter 4 and an output end of the D/A converter 9, and this switch 6 is closed after a predetermined time from the time when the power source switch is turned ON. The switch 6 may be closed manually or, closed automatically in response to a signal from a timer (not shown) or the like which times the predetermined time.

First, when the power source switch is turned ON (that is, at the time of the cold start), a program signal corresponding to a plurality of channels which may be received is supplied to the shift register 11. For example, the program signal may be received from a CPU (not shown). The shift register 11 generates control signals $S_{C1}, ..., S_{Cn}$ based on the program signal, and supplies the control signals $S_{C1}, ..., S_{Cn}$ to the program counter 10 and the address register 12.

The program counter 10 frequency-divides the oscillation frequency $f_0$ of the VCO 5 with frequency dividing ratios $1/N_1, ..., 1/N_n$ which are determined by the control signals $S_{C1}, ..., S_{Cn}$, and successively supplies divided frequencies $f_0/N_1, ..., f_0/N_n$ to the phase comparator 2. Hence, the phase comparator 2 successively generates control voltages $V_{C1}, ..., V_{Cn}$ for controlling the VCO 5 based on the divided frequencies $f_0/N_1, ..., f_0/N_n$. The control voltages $V_{C1}, ..., V_{Cn}$ are successively supplied to the A/D converter 7 via the charge pump 3 and the lowpass filter 4, and are successively converted into digital control signals and supplied to the RAM 8.

On the other hand, the control signals $S_{C1}, ..., S_{Cn}$ from the shift register 11 are successively supplied to the address register 12. Hence, the address register 12 successively inputs address signals $S_{A1}, ..., S_{An}$ to the RAM 8 in correspondence with the control signals $S_{C1}, ..., S_{Cn}$.

Based on the address signals $S_{A1}, ..., S_{An}$, the RAM 8 successively stores the digital signals corresponding to the control voltages $V_{C1}, ..., V_{Cn}$. The switch 6 closes when the storage of all the digital signals corresponding to the control voltages $V_{C1}, ..., V_{Cn}$ ends.

When a frequency hopping modulation operation is carried out, for example, the D/A converter 9 successively converts the digital signals stored in the RAM 8 into the control voltages $V_{C1}$, ..., $V_{Cn}$ and supplies the control voltages $V_{C1}$, ..., $V_{Cn}$ to the lowpass filter 4 via the closed switch 6. Thus, the carrier frequency successively hops in synchronism with the change in the coded state of the code sequences which are specified by the control voltages $V_{C1}$, ..., $V_{Cn}$. In other words, the PLL circuit successively locks to a plurality of specific frequencies based on the control voltages $V_{C1}$, ..., $V_C$ which are derived from the digital signals read from the RAM 8 based on the address signals $S_{A1}$, ..., $S_{An}$. For this reason, although the time constant of the lowpass filter 4 greatly affects the lock-up time of the closed loop formed in conventional PLL circuit shown in FIG.1, the lock-up time of this embodiment is unaffected by the time constant of the lowpass filter 4 and it is therefore possible to reduce the lock-up time compared to the conventional PLL circuit.

When the PLL circuit is to lock to a constant frequency, the PLL circuit can carry out a normal PLL operation by opening the switch 6.

In addition, when carrying out an intermittent operation described above, it is possible to quickly lock the PLL circuit to a target frequency by reading from the RAM 8 a digital signal corresponding to a specific one of the control voltages $V_{C1}$, ..., $V_{Cn}$.

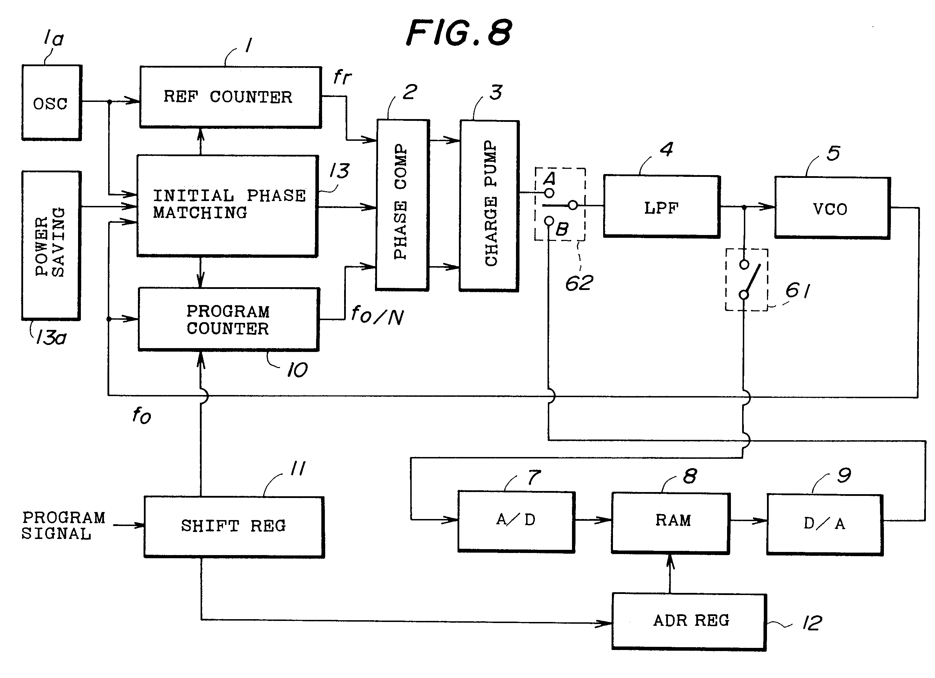

Next, a description will be given of a first modification of the second embodiment, by referring to FIG.8. In this first modification, the second embodiment is applied to the type of PLL circuit shown in FIG.3. In FIG.8, those parts which are the same as those corresponding parts in FIGS.3 and 7 are designated by the same reference numerals, and a description thereof will be omitted.

As shown in FIG.8, a first switch 61 is provided between an output end of the lowpass filter 4 and an input end of the A/D converter 7, and a second switch 62 is provided between an output end of the charge pump 3 and an input end of the lowpass filter 4.

For example, when the power source switch is turned ON and a frequency hopping modulation is to be carried out, the first switch 61 is turned ON and the second switch 62 is switched from a position A to a position B after a predetermined time elapses from the time when the power source switch is turned ON.

When the power source switch is turned ON for the second time and the phases at the phase comparator 2 are to be matched to a single frequency, it is possible to quickly match the phases based on the initial phase signals from the initial phase matching circuit 13 without the need to read the digital signals corresponding to the control voltages $V_{C1}$, ..., $V_{Cn}$ from the RAM 8. In addition, the lock-up time during the intermittent operation can be reduced, thereby making it possible to reduce the power consumption of the PLL circuit.

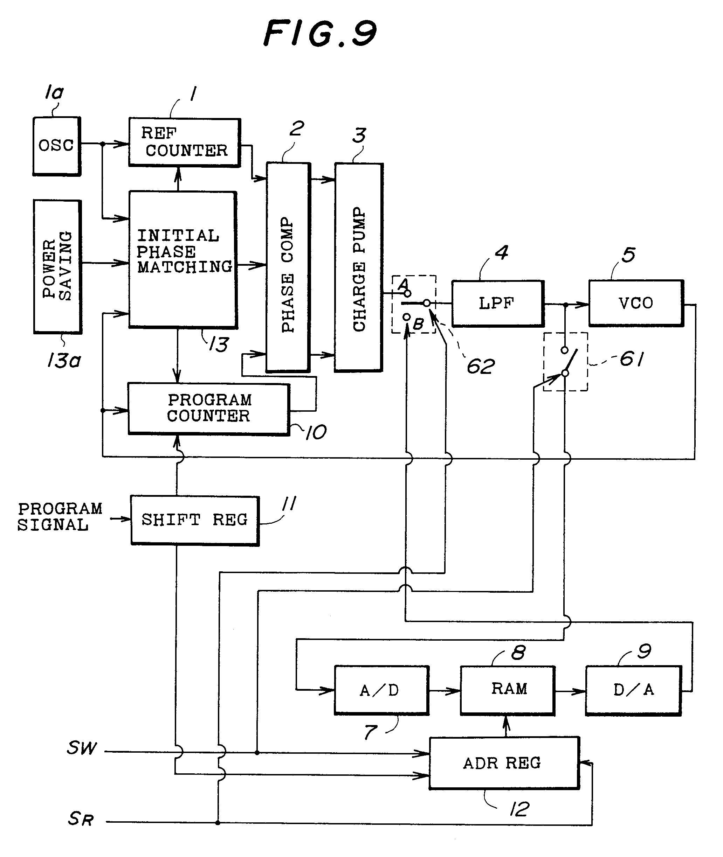

Next, a description will be given of a second modification of the second embodiment, by referring to FIG.9. In this second modification, the second embodiment is applied to the type of PLL circuit shown in FIG.3. In FIG.9, those parts which are the same as those corresponding parts in FIGS.3, 7 and 8 are designated by the same reference numerals, and a description thereof will be omitted.

As shown in FIG.9, the circuit construction of this second modification is basically the same as that of the first modification. However, in this second modification, the first switch 61 is controlled by a write signal $S_W$ and the second switch 62 is controlled by a read signal $S_R$. The read and write signals $S_R$ and $S_W$ are also supplied to the address register 12. For example, the read and write signals $S_R$ and $S_W$ are output from the same CPU (not shown) which outputs the program signal which is supplied to the shift register 11.

When the write signal $S_W$ is supplied to the address register 12, the address register 12 successively supplies the address signals $S_{A1}$, ..., $S_{An}$ to the RAM 8 in response to the write signal $S_W$. In addition, the first switch 61 is closed in response to the write signal $S_W$ so that a cold start initial operation is carried out.

When the cold start initial operation ends, the write signal $S_W$ ceases, thereby returning the first switch 61 to the open state. On other other hand, the read signal $S_R$ is supplied to the address register 12 and the second switch 62. The connection of the second switch 62 is switched from the position A to the position B in response to the read signal $S_R$, and the output end of the D/A converter 9 becomes coupled to the input end of the lowpass filter 4. In addition, the address register 12 successively supplies the address signals $S_{A1}$, ..., $S_{An}$ to the RAM 8 in response to the read signal $S_R$, and the digital signals corresponding to the control voltages $V_{C1}$, ..., $V_{Cn}$ are successively read out from the RAM 8 and converted into the control voltages $V_{C1}$, ..., $V_{Cn}$ by the D/A converter 9. The control voltages $V_{C1}$, ..., $V_{Cn}$ output from the D/A converter 9 are successively supplied to the lowpass filter 4 via the switch 62. Hence, the lock-up time of the PLL circuit can be reduced when carrying out a frequency hopping modulation operation, for example.

In each of the embodiments and modifications described above, the control voltages $V_{C1}$, ..., $V_{Cn}$ successively output from the D/A converter 9 are supplied to the input end of the lowpass filter 4. However, it is also possible to supply the control voltages $V_{C1}$, ..., $V_{Cn}$ which are successively output from the D/A converter 9 to the output end of the lowpass filter 4, that is, directly to the input end of the VCO 5. This may be easily understood from FIG.6 which shows the operating principle of the second embodiment.

The RAM 8 of the above described embodiments and modifications store the digital signals corresponding to the control voltages $V_{C1}$, ..., $V_{Cn}$ which are generated for the plurality of channels. However, the RAM 8 may of course additionally store channel information such as the station name of each channel, the frequency of each channel and the genre of each channel.

In addition, the control voltages $V_{C1}$, ..., $V_{Cn}$ which are derived from the digital signals read out from the RAM 8 and/or the channel information read out from the RAM 8 may be supplied to an output device (not shown). For example, when the output device is a display device, it is possible to display the channel information and the like read out from the RAM 8. Similarly, when the output device is a notifying means such as an indicator lamp, it is possible to notify the channel information and the like to the operator.

When the switches 6, 61 and 62 are made of analog switches, it is possible to synchronize the switching operation to the read and write operations of the RAM 8 as in the case of the second modification shown in FIG.9.

Depending on the number of bits allocated for each digital signal which is stored in the RAM 8, it may not always be possible to read out from the RAM 8 a digital signal which will immediately lock the PLL circuit. However, it is still possible to read from the RAM 8 a digital signal which is extremely close to the digital signal which will immediately lock the PLL circuit, and the lock-up time can still be considerably reduced compared to the conventional PLL circuit.

In addition, the memory 8 shown in FIG.6 is not limited to a RAM, and for example, an electrically erasable programmable read only memory (EEPROM) may be used as the memory 8. In this case, it is not essential to write the information into the memory (EEPROM) 8 every time the power source is turned ON, and it is sufficient to write the information once in every predetermined number of times the power source is turned ON.

Further, the present invention is not limited to these embodiments, but various variations and modifications may be made without departing from the scope of the present invention.

**Claims**

1. A phase locked loop circuit which is operatively coupled to a power source, said phase locked loop circuit comprising phase comparator means (2, 3) for comparing phases of an input signal and a feedback signal, characterized in that there are provided: memory means (7, 8), coupled to said phase comparator means (2, 3), for storing information related to the input signal; control voltage output means (15), coupled to said memory means, for outputting a control voltage based on the information read out from said memory means; and a feedback loop circuit (4, 5, 10), coupled to said control voltage output means, including a voltage controlled oscillator (5) whose oscillation frequency is controlled by the control voltage received from said control voltage output means, said feedback loop circuit supplying to said phase comparator means as the feedback signal a signal which is derived from an output signal of said voltage controlled oscillator.

2. The phase locked loop circuit as claimed in claim 1, characterized in that said feedback loop circuit (4, 5, 10) includes a lowpass filter (4) which is coupled between an output end of said phase comparator means (2, 3) and an input end of said voltage controlled oscillator (5).

3. The phase locked loop circuit as claimed in claim 2, characterized in that said phase comparator means (2, 3) includes a phase comparator (2) which compares the phases of the input signal and the feedback signal and a charge pump (3) which outputs a boosted signal which is dependent on a phase error between the two compared signals, said boosted signal output from said charge pump being supplied to said lowpass filter (4), and said feedback loop circuit (4, 5, 10) further includes dividing means (10) for frequency-dividing the output oscillation frequency of said voltage controlled oscillator (5) and supplying a frequency divided signal to said phase comparator as the feedback signal.

4. The phase locked loop circuit as claimed in claim 3, characterized in that said memory means (7, 8) includes an analog-to-digital converter (7) for converting an output signal of said lowpass filter (4) into a digital signal, and a memory (8) which receives the digital signal from said analog-to-digital converter.

5. The phase locked loop circuit as claimed in claim 4, which further comprises control means (50), coupled to said dividing means (10) and said memory means (7, 8), for controlling a frequency dividing ratio of said dividing means and for controlling read and write operations and a storage location of said memory means.

6. The phase locked loop circuit as claimed in any of claims 1 to 5, characterized in that said phase comparator means (2, 3) successively receives the input signal of each of a plurality of channels.

7. The phase locked loop circuit as claimed in any of claims 1 to 6, characterized in that there are further provided a crystal oscillator (1a) for generating an oscillation signal, and counter means (1) for generating the input signal based on the oscillation signal.

8. The phase locked loop circuit as claimed in any of claims 1 to 7, characterized in that said memory means (7, 8) stores the information related to the input signal when the power source is turned ON, and said control voltage output means (15) outputs the control voltage based on the information read out from said memory means after a predetermined time elapses from a time when the power source is turned ON.

9. A phase locked loop circuit comprising phase comparator means (2, 3) for comparing phases of an input signal and a feedback signal and for outputting an output signal dependent on a phase error between the two compared signals; lowpass filter means (4), coupled to said phase comparator means, for filtering the output signal of said phase comparator means into a control signal; and a feedback loop circuit (5, 10) including a voltage controlled oscillator (5) which is coupled to said lowpass filter means, said voltage controlled oscillator oscillating at an oscillation frequency controlled by the control signal received from said lowpass filter means, said feedback loop circuit supplying a signal which is derived from an output signal of said voltage controlled oscillator to said phase comparator means as the feedback signal, characterized in that there are provided: switching means (6, 61, 62), coupled to said lowpass filter means (4), having first and second states; an analog-to-digital converter (7), coupled to said switching means, for converting the control signal which is received from said lowpass filter means via said switching means in the first state into a digital signal; memory means (8), coupled to said analog-to-digital converter, for storing the digital signal output from said analog-to-digital converter; and a digital-to-analog converter (9), coupled to said memory means and said switching means, for converting the digital signal read out from said memory means into an analog signal and for supplying the analog signal to said switching means; said switching means in the second state supplying the analog signal from said digital-to-analog converter to one of said lowpass filter means and said voltage controlled oscillator.

10. The phase locked loop circuit as claimed in claim 9, characterized in that at least said phase comparator means (2, 3), said switching means (6, 61, 62), said analog-to-digital converter (7), said memory means (8) and said digital-to-analog converter (9) are formed on a single semiconductor integrated circuit chip.

11. The phase locked loop circuit as claimed in claim 9 or 10 which is operatively coupled to a power source, characterized in that said switching means (6, 61, 62) takes the first state when the power source turns ON and takes the second state after a predetermined time elapses from a time when the power source turns ON.

12. The phase locked loop circuit as claimed in any of claims 9 to 11, characterized in that said switching means (6, 61, 62) includes a switch (6) which is coupled between an output of said digital-to-analog converter (9) and an input of said lowpass filter means (4), and a line which couples an output of said lowpass filter means to an input of said analog-to-digital converter (7), said switch being open in the first state of said switching means and being closed in the second state of said switching means.

13. The phase locked loop circuit as claimed in any of claims 9 to 12, characterized in that said feedback loop circuit (5, 10) includes a dividing circuit (10) which is coupled between said voltage controlled oscillator (5) and said phase comparator means (2, 3) for frequency-dividing the output oscillation frequency of said voltage controlled oscillator and for outputting the feedback signal.

14. The phase locked loop circuit as claimed in claim 13, characterized in that there are further provided first means (12) for generating in response to a program signal a first control signal which controls a frequency-dividing ratio of said dividing circuit (10) and a second control signal, and second means (12) coupled to said memory means (8) for specifying a storage location within said memory means in response to the second control signal.

15. The phase locked loop circuit as claimed in any of claims 9, 10, 11, 13 and 14, characterized in that said switching means (6, 61, 62) includes a first switch (61) which is coupled between an output of said lowpass filter means (4) and an input of said analog-to-digital converter (7), said first switch being closed in the first state of said switching means and open in the second state of said switching means, and a second switch (62) which couples an output of said phase comparator means (2, 3) to an input of said lowpass filter means in the first state of said switching means and couples an output of said digital-to-analog converter (9) to the input of said lowpass filter means in the second state of said switching means.

16. The phase locked loop circuit as claimed in claim 15, characterized in that said first switch (61) is closed in response to a first signal and said second switch (62) couples the output of said digital-to-analog converter (9) to the input of said lowpass filter means (4) in response to a second signal.

17. The phase locked loop circuit as claimed in claim 16, characterized in that there are further provided first means (11) for generating in response to a program signal a first control signal which controls a frequency-dividing ratio of said dividing circuit (10) and a second control signal, and second means (12) coupled to said memory means (8) for specifying a storage location within said memory means in response to the second control signal, said second means making a write operation with respect to said memory means in response to the first signal and making a read operation with respect to said memory means in response to the second signal.

18. The phase locked loop circuit as claimed in any of claims 9 to 17, characterized in that there is further provided initial phase matching means (13a, 13), coupled to said voltage controlled oscillator (5), for generating an initial phase signal based on the input signal and the output signal of said voltage controlled oscillator during an initial operation in which a target frequency is set, said initial phase signal being supplied to said phase comparator (2, 3) so that an initial phase matching of the input signal and the feedback signal is made therein.

19. The phase locked loop circuit as claimed in any of claims 9 to 18, characterized in that said phase comparator means (2, 3) successively receives the input signal of each of a plurality of channels.

20. The phase locked loop circuit as claimed in any of claims 9 to 19, characterized in that there are further provided a crystal oscillator (1a) for generating an oscillation signal, and counter means (1) for generating the input signal based on the oscillation signal.

FIG.1 PRIOR ART

FIG.2

## FIG.3

# FIG.4

EP 0 471 502 A1

# FIG.5

## FIG.6

INPUT SIGNAL

PHASE COMP  2

LPF  4

CONTROL VOLTAGE

VCO  5

OSCILLATION SIGNAL

A    B    6

A/D  7    MEM  8    D/A  9

EP 0 471 502 A1

15

# FIG.7

# FIG.8

# FIG.9

**European Patent Office**

**EUROPEAN SEARCH REPORT**

Application Number

EP 91 30 7248

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 410 860 (KIPP ET AL.)<br><br>* column 1, line 61 - column 5, line 66; figures 1,2 * | 1,2,6,9,<br>12-14,19 | H03L7/189 |
| Y | | 3-5,7,<br>15,16,<br>18,20 | |
| A | | 17 | |
| | --- | | |
| X | FR-A-2 535 545 (THOMSON-CSF)<br><br>* page 4, line 6 - page 8, line 15; figures 1-7 * | 1,2,8,9,<br>11,13 | |
| Y | | 3,4,7,<br>15,16,20 | |
| | --- | | |
| X | EP-A-0 041 882 (THOMSON-CSF)<br>* page 5, line 33 - page 11, line 34 *<br>* page 13, line 2 - page 17, line 32; figures 3-9 * | 1,2,6 | |
| Y | | 3-5,7 | **TECHNICAL FIELDS SEARCHED (Int. Cl.5)** |
| A | | 10 | |
| | --- | | |
| Y | 37TH IEEE VEHICULAR TECHNOLOGY CONFERENCE<br>1 June 1987, TAMPA, FLORIDA,US<br>pages 435 - 440;<br>JUN'ICHI NAKAGAWA ET AL.: 'HANDHELD TELEPHONE FOR 800 MHz-BAND CELLULAR RADIO SYSTEMS'<br>* page 438, left column, line 6 - page 439, left column, line 33; figures 8-10 * | 3-5,7,<br>18,20 | H03L |
| | ----- | | |

The present search report has been drawn up for all claims

| Place of search | Date of completion of the search | Examiner |
|---|---|---|
| THE HAGUE | 11 NOVEMBER 1991 | BALBINOT H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)